Europäisches Patentamt

European Patent Office

Office européen des brevets

(11) Publication number: 0 379 592
A1

# EUROPEAN PATENT APPLICATION
## published in accordance with Art. 158(3) EPC

(21) Application number: 89907813.3

(22) Date of filing: 28.06.89

(86) International application number:
PCT/JP89/00643

(87) International publication number:
WO 90/00117 (11.01.90 90/02)

(51) Int. Cl.⁵: B42D 15/02, G06K 19/00,
G11C 5/00, H01L 25/00,
H01L 25/14

(30) Priority: 29.06.88 JP 86505/88 U
20.06.89 JP 157828/89
20.06.89 JP 157829/89
20.06.89 JP 157830/89
20.06.89 JP 157831/89
20.06.89 JP 157832/89

(43) Date of publication of application:
01.08.90 Bulletin 90/31

(84) Designated Contracting States:
AT BE CH DE FR GB IT LI LU NL SE

(71) Applicant: MATSUSHITA ELECTRIC
INDUSTRIAL CO. LTD.
1006 Oaza-Kadoma
Kadoma Osaka 571(JP)

(72) Inventor: KUMA, Kikuo
4-15, Ikuno 4-chome,Katano-shi
Osaka 576(JP)
Inventor: SAKUTA, Hiroshi
4-8, Imazuminami
1-chome,Tsurumi-ku,Osaka-shi
Osaka 538(JP)
Inventor: ITOH, Zenichiro
17-16, Sugiyamate 3-chome,Hirakata-shi
Osaka 573-01(JP)
Inventor: HATADA, Kenzo
8-3, Nanseidai 4-chome,Katano-shi
Osaka 576(JP)

(74) Representative: Dr. Elisabeth Jung Dr. Jürgen
Schirdewahn Dipl.-Ing. Claus Gernhardt
P.O. Box 40 14 68 Clemensstrasse 30
D-8000 München 40(DE)

(54) IC MEMORY CARD.

(57) Many memory LSI chips (6), (6') are stacked on a printed wiring board (2) that has a predetermined area in order to increase the memory capacity, the ends of conductor leads (12), (12') from common electrodes of the stacked memory LSI chips are overlapped in the direction of stack and are connected to a conductor wiring (16) of the printed wiring board, and the ends of conductor leads (15), (15') from non-common electrodes are connected to the corresponding conductor wirings (17), (18) of the printed wiring board for each of the layers of the stacked chips. This laminate structure of LSI chips reduces the wiring space and the cost of the printed wiring board, the signals are transmitted at high speeds, and insulation is maintained among the stacked LSI chips, contributing to improving reliabil-

ity of a memory card.

## Fig. I

## TITLE OF THE INVENTION

IC memory card

## TECHNICAL FIELD

The present invention relates to an IC memory card containing inside a large number of memory LSI chips.

## BACKGROUND ART

IC memory card are utilized in various fields as portable information memory apparatus which contains therein LSI's such as RAM's and ROM's. In recent years, associating with expansions of their uses, IC memory cards having large memory sizes, i.e., IC memory cards of a large memory capacity have become to be demanded. And, in such a large memory capacity IC memory card, a large number of LSI's must be installed in a high density on a printed circuit board having a certain definite areal size.

Hereupon, as for the high density memory LSI installation means, it has been considered to be efficient way that conductor leads are connected to respective electrodes of bare-chipped LSI's in a so-called film-carrier scheme and then those LSI chips are arranged in flat-plane-manner over a printed circuit board and thereby they are installed.

In the following, referring to accompanying drawings, explanation is given on the structure of IC memory cards of such the prior art as described above in which a large number of LSI's are installed on a printed circuit board.

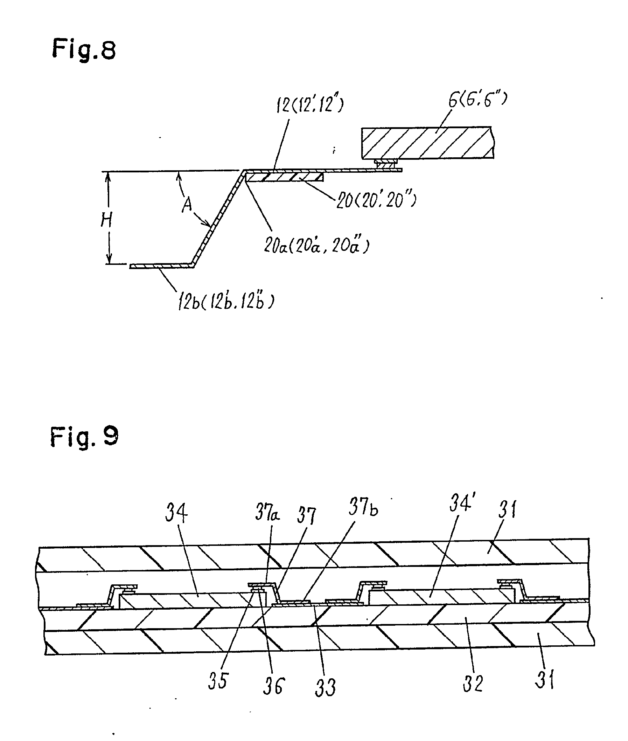

FIG.9 is a cross-sectional drawing showing an IC memory card of prior art. In FIG.9, numeral 31 is a case, in which a printed circuit board 32 is contained. On the printed circuit board 32, a printed conductor circuit 33 is formed. Numerals 34 and 34' are memory LSI chips which are arranged in flat-plane-manner over the printed circuit board 32. To an electrode 35 of the memory LSl chip 34, an end part 37a of a conductor lead 37 are connected via a metal projection 36 by means of the film-carrier scheme. The opposite end part 37b of the conductor lead 37 is connected to the printed conductor circuit-wiring 33. Since bare-chips are used in such manner as has been described above, occupying area of memory LSl's on the printed circuit board is comparatively small.

In the constitution of prior art described above, however, when the number of LSI chips becomes large, their occupying area becomes also large, since the memory LSI chips are arranged in flat-plane-manner over the printed circuit board. Accordingly, for a printed circuit board having a given definite area, the number of memory LSI chips which can be installed thereon is necessarily limited. And, when the number of memory LSI chips increases, length of conductor circuit-wiring of the printed circuit board which connects between conductor leads connected to electrodes of those memory LSI chips becomes long, and hence the area of circuit-wiring space increases, thus there has been a problem that the cost of the printed circuit board become high and at the same time the signal propagation speed inevitably drops.

DISCLOSURE OF THE INVENTION

The present invention is for solving the above-mentioned conventional problems, in which a large number of memory LSI chips are installed on a printed circuit board having a given area and thereby IC memory cards having large memory sizes can be realized, and thereby reducing the circuit-wiring space, it is to offer an IC memory card through which cost reduction on the printed circuit board as well as an improvement in the signal propagation speed can be realized. Furthermore, it purposes that it makes the stacking-layered assembly of memory LSI chips easier, and by ensuring the insulation between those stacked memory LSI chips the reliability as a memory card is raised.

In order to accomplish the above-mentioned purposes, the IC memory card of the present invention is of the constitution that one end parts of conductor leads are connected to electrodes of memory LSI chips, a plural number of memory LSI chips are stacked in a manner that their electrode arrangement comes at the same position, and opposite end parts of conductor leads of common electrodes of those respective stacked memory LSI chips are stacked in stacking direction and bonded to conductor circuit-wiring of a printed circuit board, and further, opposite end parts of conductor leads which are connected to non-common electrodes are bonded to respectively different printed circuit-wiring corresponding to respective ones of stacked chips. And, those respective conductor leads are formed and fixed on insulating films, and opposite free end parts of those conductor leads extended from this insulating film are bent and formed in different shapes with different bending angles corresponding to the floor of the stacked layers; and on these insulating films as well as on the printed circuit board, positioning holes are provided, and insulating material elements are inserted between those stacked chips for ensuring the insulation.

Since, by this constitution the occupying area of the memory LSI chips is reduced largely, a large memory size can be realized by loading a printed circuit board having a limited area with a large number of memory LSI chips; and at the same time, the circuit space on the printed circuit board can be reduced as a result of direct bonding of the conductor leads of common electrodes among corresponding chips on respective stacking-layered floors, and thereby cost-reduction of the printed circuit board as well as the high-speed signal propagation can be attained.

Furthermore, by the positioning holes provided on the insulating films as well as on the printed circuit board, stacking-layered assembly of memory LSI chips becomes easier, and by being formed at other end parts of conductor leads to be bent, distances between vertically adjacent memory LSI chips in this stacking-layered structure can be kept correctly, and by insertion of insulating material elements between chips, a highly reliable IC memory card can be realized.

BRIEF DESCRIPTION OF THE DRAWINGS

FIG.1 is a perspective view with a partially cut-out part of an IC memory card in one embodiment of the present invention, FIG.2 is a partial cross-sectional view thereof, FIG.3 is a block diagram of an electric circuit thereof, and Fig.4 is a perspective view showing the state of stacking-layers of memory LSI chips. FIG.5 is a partial cross-sectional view of an IC memory card in a second embodiment of the present invention, FIG.6 is a partial perspective view thereof. FIG.7 is a partial cross-sectional view of an IC memory card in a third embodiment of the present invention, and FIG.8 is a perspective view showing the state of bending of free end parts of conductor leads thereof. FIG.9 is a cross-sectional view showing an conventional IC memory card.

BEST MODE FOR EMBODYING THE INVENTION

In the following, explanation is given on the IC memory card of the present invention, referring to the drawings.

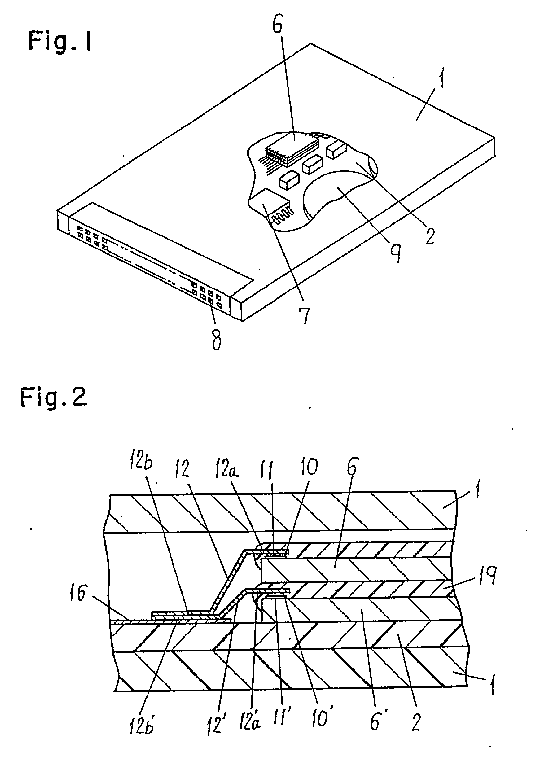

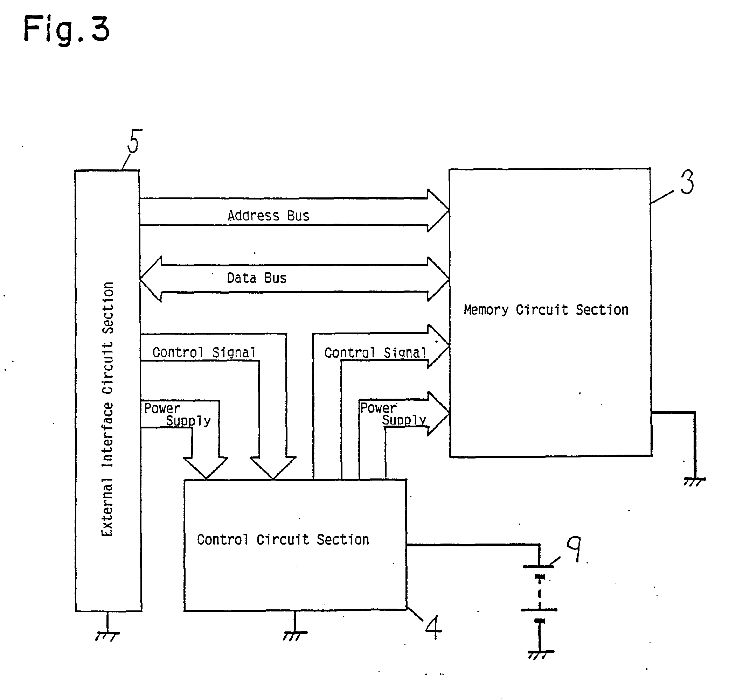

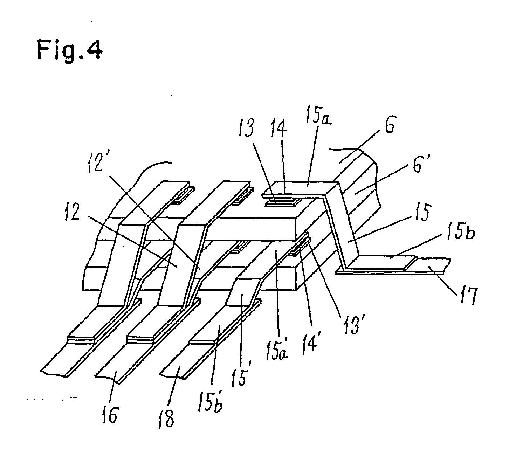

FIG.1 is a perspective view with a partially cut-out part of an IC memory card in one embodiment of the present invention, FIG.2 is a partial cross-sectional view thereof, FIG.3 is a block diagram of an electric circuit thereof, and Fig.4 is a perspective view showing the state of stacked-layers of memory LSI chips. In FIG.1 to FIG.4, numeral 1 is a case in which a printed circuit board 2 is contained. The printed circuit board 2 is comprised of a memory circuit section 3, a control circuit section 4, and an external interface circuit section 5. The memory circuit section 3 is comprised of a plural number of LSI chips 6, and they are stacked in two layers and loaded on the printed circuit board 2. The control circuit section 4 is comprised of decoder IC 7 and others, which carries out the chip selection by the address signal, the back-up control for power supply change over, and others. The external interface circuit section 5 is comprised of a connector 8 and others, and the connector 8 is to be connected to a connecting part (not shown) attached to other devices or apparatuses to be connected, and carries out power supply and signal handling to the printed circuit board 2. Numeral 9 is a battery for backing up the memory circuit section 3, and a button-type lithium battery, etc., is used thereas and it is contained in in the case 1. This battery 9 supplies a back-up power when the power supply for the memory circuit section 3 through the connector 8 is not supplied.

**EMBODIMENTS**

Next, the state of stacked-layers of memory LSI chips is described. The memory LSI chips 6 are stacking-layered over other memory LSI chips 6' in a direction that their common electrode arrangement comes at the same position. Numerals 10 and 10' are respectively electrodes of memory LSl chips 6 and 6', which are respectively connected to one end parts 12a and 12'a of conductor leads 12 and 12' through metal projections 11 and 11'. Numerals 13 and 13' are the other electrodes of memory LSl chips 6 and 6', respectively, which are connected to one end parts 15a and 15a' of conductor leads 15 and 15' through metal projections 14 and 14', respectively. Then, since the electrodes 10 and 10' are common electrodes of memory LSI chips 6 and 6', other end part 12b of the conductor lead 12 is stacked over other end part 12'b of the conductor lead 12' and they are connected together to a conductor circuit-wiring 16 of the printed-circuit board 2. However, since electrodes 13 and 13' are non-common electrodes of memory LSI chips 6 and 6', conductor leads 15 and 15' are lead out to respective positions which are different to others, then free end parts 15b and 15'b are connected to different conductor circuit-wirings 17 and 18

7

of the printed-circuit board 2 so that they do not touch to each other.

Numeral 19 is an insulating material member comprised of such as plastics, which serves to protect the electrodes 10 and 10' and at the same time play a role of preventing possible direct contact between the back side of the memory LSI chip 6 and the end parts 12'a and 15'a of conductor leads.

As has been described above, in accordance with the present embodiment, by stack-laminating a large number of memory LSI chips 6 and loading them on a printed circuit board 2, occupying area of memory LSI chips can be reduced largely, and thus an IC memory card having a large memory capacity can be realized, since a large number of memory LSI chips 6 can be loaded on the printed circuit board 2 having a definite areal size.

Furthermore, since the opposite other end parts 12b and 12'b of of conductor leads which are from common electrodes 10 and 10' of LSI chips 6 and 6' are stacked to each other and bonded to a conductor circuit-wiring 16 of the printed circuit board 2, the circuit-wiring space becomes small, and thereby cost-reduction of the printed circuit board 2 can be attained and at the same time an IC memory card having a high signal propagation speed can be realized.

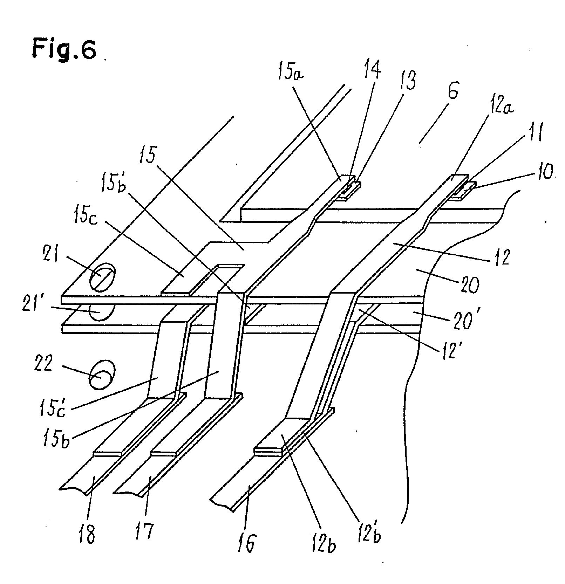

Next, on a second embodiment of the present invention, explanation is given referring to the drawings.

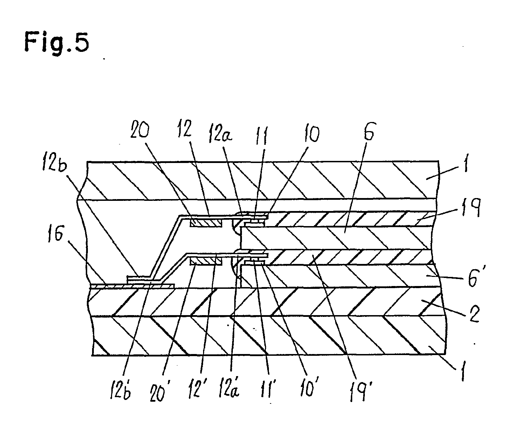

FIG.5 is a partial cross-sectional view of an IC memory
card in the second embodiment, FIG.6 is a partial
perspective view of the same. In FIG.5 and FIG.6, on a
printed circuit board 2 contained in a case 1, the same
kind of memory LSI chips 6 and 6' are stack-laminated in a
state of two layers in a direction such that their
electrode arrangement comes at the same position. To the
electrodes 10 and 10' of memory LSI chips 6 and 6', one
end parts 12a and 12'a of conductor leads 12 and 12' are
connected through metal projections 11 and 11'. The
conductor leads 12 and 12' are formed on insulating film
20 and 20', respectively, on which they are fixed thereon
by such as adhesion. Numerals 13 and 13' (not shown) are
other electrodes of memory LSI chips 6 and 6',
respectively, which are connected to one end parts 15a and
15a' (not shown) of conductor leads 15 and 15' (not shown)
through metal projections 14 and 14' (not shown),
respectively. The conductor leads 15 and 15' are formed
and held respectively on insulating films 20 and 20'.
And, since the electrodes 10 and 10' are common electrodes
of memory LSI chips 6 and 6', other end part 12b of the
conductor lead 12 is stacked over other end part 12'b of
the conductor lead 12' and they are bonded together to a
conductor circuit-wiring 16 of the printed-circuit board
2. However, conductor leads 15 and 15' are branched into two conductor leads on the insulating film 20 and 20', respectively, since electrodes 13 and 13' are non-common electrodes of memory LSI chips 6 and 6', and other end part 15b of the conductor lead 15 is bonded to conductor circuit-wiring 17 of the printed-circuit board 2, while another other end part 15c is cut out. The other end part 15'b of the conductor lead 15' is cut out, while another free end part 15'c is bonded to conductor circuit-wiring 18 of the printed-circuit board 2. In such a manner, respective other end parts of the conductor leads 15 and 15' from the non-common electrodes are connected to different circuit-wiring points 17 and 18, respectively, so that they do not to touch to each other. Numerals 19 and 19' are insulating material members comprised of such as plastics. Numerals 21 and 21' are positioning holes provided respectively on the insulating films 20 and 20', and numeral 22 is a positioning hole provided on the printed circuit board 2. Positions of respective holes correspond to each other, hence by inserting such as a positioning pin the mutual correct positioning of these insulating films and the printed circuit board can be attained easily, and thereby any possible deviation which might occur when the other end parts 12b and 12'b of the conductor leads 12 and 12' are stacked to each other can be prevented.

As has been described above, in accordance with the present embodiment, by stack-laminating two memory LSI chips 6 and 6' and loading them on the printed circuit board 2, the occupying area of the memory LSI chips 6 and 6' can be halved, and hence a large number of memory LSI chips can be installed on a printed circuit board 2 of a given areal size, and thereby an lC card having a large memory capacity can be realized.

Furthermore, since the other end parts 12b and 12'b of of conductor leads 12 and 12' from common electrodes of memory LSI chips 6 and 6' are stacked to each other and bonded to a conductor circuit-wiring 16 of the printed circuit board 2, the circuit-wiring space becomes small, and thereby, cost-reduction of the printed circuit board 2 can be attained, and at the same time an IC memory card having a high signal propagation speed can be realized.

And, by inserting such as a positioning pin into the positioning holes 21 and 21' on the insulating films 20 and 20' and the positioning hole 22 on the printed circuit board 2, respectively, stacking-layered assembly process can be carried out easily with an excellent accuracy, and thereby possible short-circuiting due to deviations between those end parts 12b and 12'b of conductor leads 12 and 12' can be prevented, and thus an lC memory card which can be assembled easily and having high reliability can be realized.

11

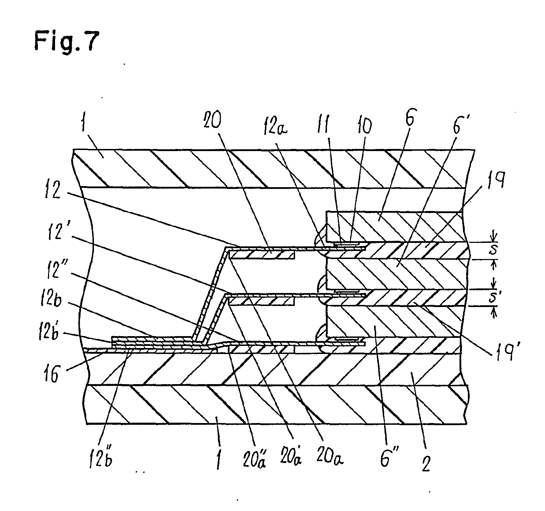

Next, on a third embodiment of the resent invention, explanation is given referring to the drawings. FIG.7 is a partial cross-sectional view of an IC memory card in the third embodiment, FIG.8 is a cross-sectional view showing the state of bending of the free end parts of the conductor leads. In FIG.7 and FIG.8, on a printed circuit board 2 contained in a case 1, the same kind of memory LSI chips 6, 6' and 6" are stack-laminated in a state of three layers in a direction that their electrode arrangement comes at the same position. To the electrode 10 of memory LSI chip 6, one end part 12a of conductor lead 12 is connected through metal projections 11. The conductor lead 12 is formed and held on the insulating film 20. The above-mentioned constitution is the same for other memory LSI chips 6' and 6". Other end parts 12b, 12'b, and 12"b of conductor leads 12, 12', and 12" are formed, respectively, at the edge parts 20a, 20'a, 20"a having respectively different values for the bending height H and the bending angle A which are shown in FIG.8. Then, since the electrodes 10, 10', and 10" are common electrodes of memory LSI chips 6, 6', and 6", the other end parts 12b, 12'b, 12"b of respective conductor leads are stacked to each other in an order of their lamination, and they are bonded together to a conductor circuit-wiring 16 of the printed-circuit board 2 by means of such as soldering. Distances S and S' between stack-laminated LSI

12

chips 6 and 6' and between 6' and 6", respectively, are held to their correct values (0.04 mm to 0.5 mm) depending on their shapes formed by bending of those other end parts 12b, 12'b, 12"b of conductor leads. Numerals 19 and 19' are insulating material member inserted between memory LSI chips 6 and 6' and between 6' and 6".

As has been described above, in accordance with the present embodiment, a plural number of memory LS1 chips 6 and so forth are stack-layered on the printed circuit board 2, and at the same time, the other end parts 12b, 12'b, 12"b of respective conductor leads connected to the common electrode 10 are stacked to each other in an order of their lamination, and they are bonded together to a conductor circuit-wiring 16 of the printed-circuit board 2. Therefore, since a large number of memory LSI chips 6 and so forth can be loaded on the printed circuit board 2 of a given areal size, an IC memory card having a large memory capacity can be realized, and the circuit-wiring space becomes small, thereby cost-reduction of the printed circuit board 2 can be attained and at the same time an IC memory card having a high signal propagation speed can be realized. Moreover, by forming the other end parts 12b, 12'b, 12"b of conductor leads into respective different forms by bending, distances between those stack-laminated LSI chips 6 and 6' are held to their appropriate values; and since, insulating material members 19 and 19' are

13

inserted therebetween, touching between the end part 12a of the conductor lead and the memory LSI chip 6' can be prevented; and thereby an IC memory card having high reliability can be realized.

As described above, in the present invention, it has a constitution that, in an 1C memory card, one end parts of conductor leads are connected to electrodes of memory LSI chips, and a plural number of memory LSI chips are stacked in a manner that their electrode arrangement comes at the same position, opposite other end parts of conductor leads which are connected to common electrodes of those respective stacked memory LSI chips are stacked and bonded to a conductor circuit-wiring on a printed circuit board, whereas other opposite other end parts of conductor leads which are connected to non-common electrodes are bonded respectively to different printed circuit-wiring from the other corresponding to respective floors of stacking-layered chips. And, those respective conductor leads are formed and fixed on insulating films and other end parts of those conductor leads extended from these insulating films are bent and formed in different shapes with different bending angles corresponding to the floor of the stacked layers; On these insulating films as well as on the printed circuit board, positioning holes are provided, and insulating material elements are inserted between those stacked chips for ensuring the insulation.

## POSSIBLE UTILITY IN INDUSTRY

As has been described above, in accordance with the present invention, since the occupying area of the memory LSI chips is reduced largely, a large memory size can be realized by loading a printed circuit board having a limited area with a large number of memory LSI chips; and at the same time, since the conductor leads of common electrodes among corresponding chips on respective stacking-layered floors are bonded directly at a common single position, the circuit wiring space on the printed circuit board can be reduced; and thereby cost-reduction of the printed circuit board as well as the high-speed signal propagation can be attained.

Furthermore, by the positioning hole on the insulating films, stacking-layered assembly of memory LSI chips becomes easier, and by the formation of other end parts of conductor leads, distances between vertically adjacent memory LSI chips in this stacking-layered structure can be kept correctly; and by the insertion of insulating material elements between chips, a highly reliable IC memory card can be realized.

TABLE OF REFERENCE NUMERALS IN THE DRAWINGS

2 ...... printed circuit board

3 ...... memory circuit section

4 ...... control circuit section

5 ...... external interface circuit section

6 ...... memory LSI chip

10 ...... electrode (common)

13 ...... electrode (non-common)

12, 15 ...... conductor leads

12a, 15a ...... one end parts of conductor leads

12b, 15b ...... other end parts of conductor leads

16, 17, 18 ...... conductor circuit-wirings

19, 19' ...... insulating material member

20 ...... insulating film

20a ...... edge part of insulating film

21, 22 ...... positioning holes

**Claim(s)**

1.    An IC memory card characterized in that a plural number of memory LSI chips are stack-laminated on a printed circuit board.

2.    An lC memory card characterized in that it includes a printed circuit board, memory LSI chips which are installed on said printed circuit board, and conductor leads whose one end parts are connected to electrodes of said memory LSI chips and opposite end parts are bonded to said printed circuit board, and a plural number of said memory LSI chips are stacked in a manner that their electrode arrangement comes at the same position, and at the same time, the conductor leads connected to common electrodes of said respective stack-laminated memory LSI chips are stacked in stacking direction and bonded to a common point of conductor circuit-wiring of said printed circuit board.

3.    An IC memory card in accordance with claim 2, wherein a plural number of conductor leads are formed on and held by insulating films.

4.    An IC memory card in accordance with claim 2, wherein other end parts of conductor leads which are connected to non-common electrodes of memory LSI chips are respectively branched into a number of stacking-layers, and among said branched respective conductor leads, except one required branch depending on floor to which the

17

relevant chip belongs, other than branched conductor leads are connected to one of different conductor circuit-wiring of corresponding floors on said printed circuit board in electrically non-conductive manner.

5. An IC memory card in accordance with claim 2, wherein other end parts of conductor leads which are connected to non-common electrodes of memory LSI chips are lead out to respective positions which are different from others depending on layered floors, and they are bonded to different conductor circuit-wiring, corresponding to the floors of said printed circuit board.

6. An IC memory card in accordance with claim 2, wherein insulating material elements are inserted between respective stacking-layered LSl chips.

7. An IC memory card in accordance with claim 2, wherein the printed circuit board is comprised of a memory circuit section, a control circuit section, and an external interface circuit section.

8. An IC memory card in accordance with claim 3, wherein other end parts of the conductor leads are bent and formed from the edge parts of said insulating films and formed into different shapes from other ones, corresponding to the floor of the stack-layered of memory LSI chips.

9. An IC memory card in accordance with claim 3, wherein a plural number of positioning holes are provided

18

on insulating films, and at the same time, on the printed circuit board, positioning holes are provided at least at two positions which correspond to said positioning holes on said insulating film.

Fig.1

Fig.2

# Fig.3

External Interface Circuit Section

Address Bus

Data Bus

Control Signal

Power
Supply

Memory Circuit Section

Control Signal

Power
Supply

Control Circuit Section

# Fig.4

## Fig.5

# Fig.6

# Fig.7

## Fig.8

## Fig.9

# INTERNATIONAL SEARCH REPORT

International Application No  PCT/JP89/00643

## I. CLASSIFICATION OF SUBJECT MATTER (if several classification symbols apply, indicate all)

According to International Patent Classification (IPC) or to both National Classification and IPC    Int. Cl⁴

B42D15/02,    G06K19/00 , G11C5/00
H01L25/00,  H01L25/14

## II. FIELDS SEARCHED

Minimum Documentation Searched :

| Classification System | Classification Symbols |
|---|---|
| IPC | B42D15/10 521 |

Documentation Searched other than Minimum Documentation
to the Extent that such Documents are Included in the Fields Searched ·

| | |
|---|---|
| Jitsuyo Shinan Koho | 1977 - 1988 |
| Kokai Jitsuyo Shinan Koho | 1973 - 1988 |

## III. DOCUMENTS CONSIDERED TO BE RELEVANT

| Category * | Citation of Document, [11] with indication, where appropriate, of the relevant passages :· | Relevant to Claim No. [13] |
|---|---|---|
| X | JP, A, 60-80232 (Nippon Telegraph & Telephone Public Corporation) 8 May 1985 (08. 05. 85) Column 2, lines 17 to 20, Figs. 2 to 3 | 1 |

* Special categories of cited documents: [iv]

"A"  document defining the general state of the art which is not considered to be of particular relevance

"E"  earlier document but published on or after the international filing date

"L"  document which may throw doubts on priority claim(s) or which is cited· to establish the publication date of another citation or other special reason (as specified).

"O"  document referring to an oral disclosure. use. exhibition or other means

"P"  document published prior to the international filing date but later than the priority date claimed

"T"  later document published after the international filing date or priority date and not in conflict with the application but cited to understand the principle or theory underlying the invention

"X"  document of particular relevance: the claimed invention cannot be considered novel or cannot be considered to involve an inventive step

"Y"  document of particular relevance: the claimed invention cannot be considered to involve an inventive step when the document is combined with one or more other such documents. such combination being obvious to a person skilled in the art

"&"  document member of the same patent family

## IV. CERTIFICATION

| Date of the Actual Completion of the International Search | Date of Mailing of this International Search Report |
|---|---|
| September 18, 1989 (18. 09. 89) | October 2, 1989 (02. 10. 89) |

| International Searching Authority | Signature of Authorized Officer |
|---|---|
| Japanese Patent Office | |